(19) Europäisches Patentamt / European Patent Office / Office européen des brevets

(11) **EP 4 485 015 A1**

(12) **EUROPEAN PATENT APPLICATION**

(43) Date of publication:
01.01.2025 Bulletin 2025/01

(21) Application number: 24183074.4

(22) Date of filing: 19.06.2024

(51) International Patent Classification (IPC):
G02B 1/14 (2015.01)      G02B 1/18 (2015.01)
G02B 5/30 (2006.01)      G02B 27/00 (2006.01)
G02B 27/01 (2006.01)

(52) Cooperative Patent Classification (CPC):
G02B 1/14; G02B 1/18; G02B 5/3033;
G02B 27/0006; G02B 27/0101

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 26.06.2023  JP 2023104239
19.04.2024  JP 2024068417

(71) Applicant: Nitto Denko Corporation
Ibaraki-shi, Osaka 567-8680 (JP)

(72) Inventors:
• MIZUSHIMA, Hiroki
Ibaraki-shi, Osaka, 567-8680 (JP)
• IZAKI, Akinori
Ibaraki-shi, Osaka, 567-8680 (JP)
• SENDA, Hiroki
Ibaraki-shi, Osaka, 567-8680 (JP)
• SUGAHARA, Atsuhiro
Ibaraki-shi, Osaka, 567-8680 (JP)

(74) Representative: Hoffmann Eitle
Patent- und Rechtsanwälte PartmbB
Arabellastraße 30
81925 München (DE)

(54) **DUST COVER AND HEAD-UP DISPLAY APPARATUS INCLUDING THE DUST COVER**

(57)      Provided is the following dust cover: the dust cover is suppressed from warping, and even when an iodine-based polarizer is used, the dust cover can suppress the polyene formation of the polarizer. The dust cover is a dust cover including: a first support plate; a polarizing plate including an iodine-based polarizer; and a second support plate, at least one of the first support plate or the second support plate having a moisture permeability of 37 g/(m²·24 hours) or more, at least one of the first support plate or the second support plate having a thickness of 200 μm or more. A distance between a center line $L_P$ of the iodine-based polarizer in a thickness direction thereof and a center line $L_D$ of the dust cover in a thickness direction thereof is 20 μm or less.

FIG.1

<u>100</u>

EP 4 485 015 A1

**Description**

BACKGROUND OF THE INVENTION

1. Field of the Invention

The present invention relates to a dust cover and a head-up display apparatus including the dust cover.

2. Description of the Related Art

A head-up display apparatus has started to be developed and put into practical use. In the head-up display apparatus, a dust cover that covers the opening portion of an optical path is arranged for preventing foreign matter such as dust from entering a housing storing a display unit or the like. Further, for example, it has been proposed that a polarizing plate be bonded to the dust cover for preventing an increase in temperature in the housing due to the incidence of sunlight (e.g., WO 2017/199916 A1) .

SUMMARY OF THE INVENTION

An iodine-based polarizer and a dye-based polarizer have typically been known as polarizers. The iodine-based polarizer may provide a dust cover having a higher heat-shielding property because its polarization degree may be higher than that of the dye-based polarizer. Meanwhile, the iodine-based polarizer is liable to cause polyene formation and warping (e.g., the warping of a dust cover) owing to high temperature, and hence the display performance of a head-up display apparatus may reduce. Accordingly, there has been required the following dust cover: the dust cover is suppressed from warping, and even when an iodine-based polarizer is used, the dust cover can suppress the polyene formation of the polarizer.

1. According to at least one embodiment of the present invention, there is provided a dust cover including: a first support plate; a polarizing plate including an iodine-based polarizer; and a second support plate, at least one of the first support plate or the second support plate having a moisture permeability of 37 $g/(m^2 \cdot 24\ \text{hours})$ or more, at least one of the first support plate or the second support plate having a thickness of 200 um or more, wherein a distance between a center line $L_P$ of the iodine-based polarizer in a thickness direction thereof and a center line $L_D$ of the dust cover in a thickness direction thereof is 20 um or less.

2. According to at least one embodiment of the present invention, there is provided a dust cover including: a first support plate; a polarizing plate including an iodine-based polarizer; and a second support plate, at least one of the first support plate or the second support plate having a moisture permeability of 37 $g/(m^2 \cdot 24\ \text{hours})$ or more, at least one of the first support plate or the second support plate having a tensile modulus of elasticity of 1,600 MPa or more, which is measured at 23°C ± 2°C, wherein a distance between a center line $L_P$ of the iodine-based polarizer in a thickness direction thereof and a center line $L_D$ of the dust cover in a thickness direction thereof is 20 um or less.

3. In the dust cover according to the above-mentioned item 1 or 2, the support plates each may include a substrate and a surface resin layer.

4. In the dust cover according to the above-mentioned item 3, the substrate may contain a polycarbonate-based resin.

5. In the dust cover according to the above-mentioned item 3 or 4, the surface resin layer may contain polymethyl methacrylate.

6. In the dust cover according to any one of the above-mentioned items 3 to 5, the surface resin layer may have a thickness of 30 um or more.

7. In the dust cover according to any one of the above-mentioned items 1 to 6, an iodine content of the polarizer may be from 2.2 wt% to 4.0 wt%.

8. According to at least one embodiment of the present invention, there is provided a head-up display apparatus. The head-up display apparatus includes: a display unit configured to emit projection light; at least one reflector configured to reflect the projection light; and the dust cover of any one of the above-mentioned items 1 to 7.

BRIEF DESCRIPTION OF THE DRAWINGS

FIG. 1 is a schematic sectional view of a dust cover according to at least one embodiment of the present invention.

FIG. 2 is a schematic sectional view of a head-up display apparatus according to at least one embodiment of the present invention.

DESCRIPTION OF THE EMBODIMENTS

Embodiments of the present invention are described below. However, the present invention is not limited to these embodiments.

A. Overall Configuration of Dust Cover

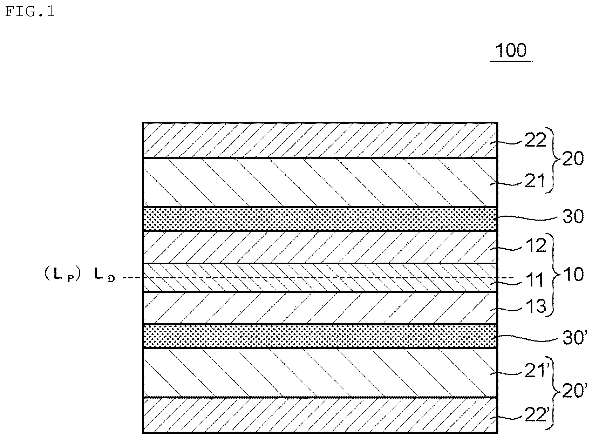

FIG. **1** is a schematic sectional view of a dust cover according to at least one embodiment of the present invention. A dust cover **100** of the illustrated example includes: a first support plate **20**; a polarizing plate **10** including an iodine-based polarizer **11**; and a second support plate **20'**. The first support plate **20** and the second support plate **20'** may be the same support plate, or may be different support plates. In at least one embodiment of the present invention, the first support plate **20** and the second support plate **20'** preferably include substrates **21** and **21'**, and surface resin layers **22** and **22'**. The polarizing plate **10** typically includes the iodine-based polarizer **11**, and protective layers **12** and **13** arranged on both the sides of the polarizer **11**. The polarizing plate **10** may further include any appropriate other layer except the protective layers. The other layer is, for example, a retardation layer. The respective members of the dust cover may be laminated via any appropriate adhesion layer (not shown). Specific examples of the adhesion layer include an adhesive layer and a pressure-sensitive adhesive layer. In the illustrated example, the first support plate **20** and the polarizing plate **10** are laminated via a first pressure-sensitive adhesive layer **30**. In addition, the polarizing plate **10** and the second support plate **20'** are laminated via a second pressure-sensitive adhesive layer **30'**. In the dust cover **100**, a distance between the center line $L_P$ of the iodine-based polarizer **11** in its thickness direction and the center line $L_D$ of the dust cover **100** in its thickness direction is 20 um or less. In the illustrated example, the $L_P$ and the $L_D$ coincide with each other. At least one of the first support plate **20** or the second support plate **20'** has a thickness of 200 um or more. In the illustrated example, the first support plate **20** and the second support plate **20'** each have a thickness of 200 $\mu$m or more. The thicknesses of the first support plate **20** and the second support plate **20'** may be identical to or different from each other. In addition, at least one of the first support plate **20** or the second support plate **20'** has a moisture permeability of 37 g/(m$^2$·24 hours) or more. The moisture permeabilities of the first support plate **20** and the second support plate **20'** may be identical to or different from each other. The iodine-based polarizer has a polarization degree higher than that of a dye-based polarizer, and has a heat-shielding property higher than that of the dye-based polarizer, and hence can further alleviate damage caused by sunlight to the inside of a head-up display apparatus (e.g., an image display apparatus). Meanwhile, in a dust cover using the iodine-based polarizer, the warping of the dust cover and the polyene formation of the polarizer become problems, and as a result, the display performance of a head-up display apparatus to which the dust cover has been applied may reduce. Particularly in an on-vehicle head-up display apparatus, such problems may be remarkable because the apparatus may be placed under an environment at higher temperature. According to the dust cover of at least one embodiment of the present invention, there can be obtained the following dust cover: the dust cover is suppressed from warping, and even when an iodine-based polarizer is used, the dust cover can suppress the polyene formation of the polarizer. As a result, even when the dust cover is used in an on-vehicle head-up display apparatus, damage caused by sunlight to the inside of the head-up display apparatus can be further alleviated.

As described above, in the dust cover according to at least one embodiment of the present invention, the distance between the center line $L_P$ of the iodine-based polarizer **11** in the thickness direction and the center line $L_D$ of the dust cover **100** in the thickness direction is 20 um or less. The distance between the $L_P$ and the $L_D$ is preferably 18 um or less, more preferably 15 um or less, still more preferably 10 um or less. The distance between the $L_P$ and the $L_D$ is preferably as small as possible, and may be 0 um, that is, the center line $L_P$ of the iodine-based polarizer **11** in the thickness direction and the center line $L_D$ of the dust cover **100** in the thickness direction may be at the same position. When the distance between the $L_P$ and the $L_D$ falls within the above-mentioned ranges, the warping of the dust cover can be further suppressed.

The thickness of the dust cover may be set to any appropriate value. The thickness of the dust cover is preferably from 300 um to 750 $\mu$m, more preferably from 350 um to 700 $\mu$m, still more preferably from 400 um to 650 $\mu$m, particularly preferably from 450 um to 600 um. When the thickness of the dust cover falls within the above-mentioned ranges, a dust cover excellent in dust resistance and heat-shielding property can be obtained.

The dust cover 100 is typically transparent. The term "transparent" as used herein means that the dust cover has a property of transmitting visible light having a wavelength of from 360 nm to 830 nm. The term "transparent" includes: a case in which the dust cover is substantially free from absorbing visible light, and transmits light having any wavelength in a visible light region (colorless transparent); and a case in which the dust cover absorbs light beams having some wavelengths in the visible light region, and transmits light having a wavelength except the wavelengths (colored transparent). The dust cover is preferably colorless transparent. The total light transmittance of the dust cover is preferably 50% or more, more preferably 70% or more, still more preferably 90% or more. The total light transmittance is a value measured in conformity with JIS K 7375.

The surface shape of the dust cover **100** may be designed into any appropriate shape in accordance with the shape of the opening portion of a head-up display apparatus to which the dust cover is applied. For example, the portion of the dust cover that covers the opening portion may include only a flat surface or only a curved surface, or the portion that covers the opening portion may include a plurality of flat surfaces and/or a plurality of curved surfaces. Typically, the surface shape of the dust cover may include only a flat surface or only a curved surface.

The constituents of the dust cover are described in more detail below.

B. Support Plates

The first support plate **20** and the second support plate **20'** (hereinafter also referred to as "support plates") may be arranged on both the sides of the polarizing plate **10**. The first support plate **20** and the second support plate **20'** may be the same support plate, or may be different support plates. At least one of the first support plate **20** or the second support plate **20'** has a moisture permeability of 37 $g/(m^2 \cdot 24 \text{ hours})$ or more. The moisture permeability of each of the support plates is 37 $g/(m^2 \cdot 24 \text{ hours})$ or more, preferably 40 $g/(m^2 \cdot 24 \text{ hours})$ or more, more preferably 45 $g/(m^2 \cdot 24 \text{ hours})$ or more, still more preferably 50 $g/(m^2 \cdot 24 \text{ hours})$ or more. The moisture permeability of each of the support plates is, for example, 70 $g/(m^2 \cdot 24 \text{ hours})$ or less. When the moisture permeability of each of the support plates falls within the above-mentioned ranges, there can be obtained the following dust cover: the dust cover is suppressed from warping, and even when an iodine-based polarizer is used, the dust cover can suppress the polyene formation of the polarizer. The term "moisture permeability" as used herein refers to a value measured under the conditions of a temperature of 40°C and a humidity of 92%RH in conformity with JIS Z 0208.

In at least one embodiment of the present invention, at least one of the first support plate **20** or the second support plate **20'** has a thickness of 200 um or more. The thickness of each of the support plates is 200 um or more, preferably 220 um or more, more preferably 250 um or more. In addition, the thickness of each of the support plates is preferably 300 um or less. When the thickness falls within the above-mentioned ranges, there can be obtained the following dust cover: the dust cover is suppressed from warping, and even when an iodine-based polarizer is used, the dust cover can suppress the polyene formation of the polarizer. In at least one embodiment of the present invention, the thickness of each of the support plates may be, for example, less than 200 $\mu$m, and is preferably from 100 um to 150 um. In the case where the above-mentioned distance between the $L_P$ and the $L_D$ is smaller (e.g., 0 pm), even when the thickness of each of the support plates is less than 200 $\mu$m, the warping is suppressed, and even when an iodine-based polarizer is used, the polyene formation of the polarizer can be suppressed.

In at least one embodiment of the present invention, the tensile modulus of elasticity of each of the first support plate **20** and the second support plate **20'** measured at 23°C±2°C is 1,600 MPa or more. The tensile modulus of elasticity of each of the support plates measured at 23°C±2°C is 1,600 MPa or more, preferably 1,700 MPa or more, more preferably 1,800 MPa or more, still more preferably 1,900 MPa or more, particularly preferably 1,950 MPa or more. The tensile modulus of elasticity of each of the support plates measured at 23°C±2°C is preferably 3,000 MPa or less. When the tensile modulus of elasticity of each of the support plates measured at 23°C±2°C falls within the above-mentioned ranges, there can be provided the following dust cover: the dust cover is suppressed from warping, and even when an iodine-based polarizer is used, the dust cover can suppress the polyene formation of the polarizer. In this specification, the tensile modulus of elasticity of each of the support plates may be measured under the conditions of a temperature of 23°C±2°C and a humidity of 50%RH±10%RH in conformity with JIS K 7161.

Each of the support plates only needs to have a moisture permeability of 37 $g/(m^2 \cdot 24 \text{ hours})$ or more, and may be formed from any appropriate material. The material is, for example, a resin. Specific examples of the resin include: ester-based resins, such as polyethylene terephthalate and polyethylene naphthalate; cellulose-based resins, such as diacetylcellulose and triacetylcellulose; polycarbonate-based resins such as bisphenol A-based polycarbonate; acrylic resins such as polymethyl methacrylate and a lactone-modified acrylic resin; styrene-based resins, such as polystyrene and an acrylonitrile-styrene copolymer; olefin-based resins, such as polyethylene, polypropylene, a polyolefin having a cyclic structure or a norbornene structure, and an ethylene-propylene copolymer; vinyl chloride-based resins; amide-based resins such as aromatic polyamide; imide-based resins; sulfone-based resins; polyether sulfone-based resins; polyether ether ketone-based resins; polyphenylene sulfide-based resins; vinyl alcohol-based resins; vinylidene chloride-based resins; vinyl butyral-based resins; arylate-based resins; polyoxymethylene-based resins; and epoxy-based resins. Of those, a polycarbonate-based resin is preferably used. The use of the polycarbonate-based resin can provide a support plate excellent in transparency, impact resistance, heat resistance, durability, and bending processability. Those resins may be used alone or in combination thereof.

In at least one embodiment of the present invention, the support plates each include a substrate and a surface resin layer. The use of the support plates each including the substrate and the surface resin layer can provide a dust cover, which is further improved in heat resistance, is further suppressed from warping, and can further suppress the polyene formation of a polarizer.

B-1. Substrate

The substrate of each of the support plates may be formed from any appropriate material. For example, a resin may be used, and specifically, the resins given as the examples of the resin for forming each of the above-mentioned support plates may each be used. A polycarbonate-based resin is preferably used as the material for forming the substrate. The use of the polycarbonate-based resin can provide a support plate excellent in transparency, impact resistance, heat resistance, durability, and bending processability. Those resins may be used alone or in combination thereof.

The thickness direction retardation Rth(550) of the substrate is preferably 50 nm or less, more preferably 20 nm or less, still more preferably 10 nm or less, particularly preferably from 0 nm to 5 nm. When the Rth(550) falls within the above-mentioned ranges, the dust cover may be suitably used as a dust cover for a head-up display. In this specification, the thickness direction retardation "Rth($\lambda$)" refers to a thickness direction retardation measured at 23°C with light having a wavelength of $\lambda$ nm. Accordingly, the term "Rth(550)" refers to a thickness direction retardation measured at 23°C with light having a wavelength of 550 nm. When the thickness of a layer (film) is represented by "d" (nm), the Rth($\lambda$) is determined from the equation "Rth($\lambda$)=(nx-nz)×d" where "nx" represents a refractive index in the direction in which a refractive index in the plane of the layer becomes maximum (that is, a slow axis direction), and "ny" represents a refractive index in the direction perpendicular to the slow axis in the plane (that is, a fast axis direction).

The thickness of the substrate may be set to any appropriate thickness. The thickness of the substrate is preferably from 100 um to 270 $\mu$m, more preferably from 170 um to 265 um. When the thickness of the substrate falls within the above-mentioned ranges, there can be provided the following dust cover: the dust cover is suppressed from warping, and even when an iodine-based polarizer is used, the dust cover can suppress the polyene formation of the polarizer.

The substrate may contain any appropriate additive except the above-mentioned resin. Examples thereof include an infrared absorber, a UV absorber, and a flame retardation stabilizer. Those additives may be used alone or in combination thereof.

B-2. Surface Resin Layer

The formation of the surface resin layer can further improve, for example, the heat resistance of the dust cover. The surface resin layer may be formed from any appropriate resin. Examples of the resin include: a (meth)acrylic resin such as polymethyl methacrylate (PMMA); a styrene-(meth)acrylate copolymer resin; a hydrogenated styrene-(meth) acrylate copolymer resin (the benzene ring of a styrene component is made partially alicyclic through hydrogenation); an aromatic polycarbonate resin copolymerized with a 2,2-(4-hydroxy-3-methylphenyl)alkane; and a composition including a (meth)acrylic resin copolymerized with a (meth)acrylic monomer having an aromatic ring, which is compatible with an aromatic polycarbonate resin, and the aromatic polycarbonate resin. Of those, a (meth)acrylic resin, and a (meth)acrylic resin and a hydrogenated styrene-(meth)acrylate copolymer resin (the benzene ring of a styrene component is made partially alicyclic through hydrogenation) are preferably used, and PMMA is more preferably used. When the surface resin layer is formed from such resin, there can be provided the following dust cover: the dust cover is improved in heat resistance; and moreover, the dust cover is further suppressed from warping, and even when an iodine-based polarizer is used, the dust cover can suppress the polyene formation of the polarizer. Further, a dust cover excellent in low birefringence and abrasion resistance can be provided. The term "(meth)acrylic" as used herein refers to acrylic and/or methacrylic.

The thickness of the surface resin layer is preferably 15 um or more, more preferably 20 um or more, still more preferably 25 um or more, particularly preferably 30 um or more. The thickness of the surface resin layer is preferably 60 um or less. When the thickness of the surface resin layer falls within the above-mentioned ranges, a dust cover that is further suppressed from warping can be provided.

The surface resin layer may contain any appropriate additive except the above-mentioned resin. Examples thereof include an infrared absorber, a UV absorber, and a flame retardation stabilizer. Those additives may be used alone or in combination thereof.

C. Polarizing Plate

The polarizing plate **10** typically includes the iodine-based polarizer **11,** and the protective layers **12** and **13** arranged on both the sides of the iodine-based polarizer **11.** In at least one embodiment of the present invention, the direction of the absorption axis of the polarizing plate **10** (substantially, the iodine-based polarizer **11**) is typically set to a direction substantially parallel to the polarization direction of the projection light (typically, linearly polarized light) of a head-up display apparatus in which the dust cover is adopted. The expressions "substantially parallel" and "approximately parallel" as used herein each include a case in which an angle formed between two directions is $0°\pm7°$, and the angle is preferably $0°\pm5°$, more preferably $0°\pm3°$. The expressions "substantially perpendicular" and "approximately perpendicular" each include a case in which an angle formed between two directions is $90°\pm7°$, and the angle is preferably $90°\pm5°$, more preferably $90°\pm3°$. Further, the simple expression "perpendicular" or "parallel" as used herein may include a state in which two directions are substantially perpendicular, or substantially parallel, to each other.

C-1. Polarizer

The iodine-based polarizer typically includes a resin film containing iodine as a dichroic substance. Any appropriate resin film that may be used as a polarizer may be adopted as the resin film. The resin film is typically a polyvinyl alcohol-based resin (hereinafter referred to as "PVA-based resin") film. The resin film may be a single-layer resin film, or may be a laminate of two or more layers.

The polarizer including the single-layer resin film is specifically, for example, a polarizer obtained by subjecting a PVA-based resin film to dyeing treatment with iodine and stretching treatment (typically, uniaxial stretching). The dyeing with iodine described above is performed by, for example, immersing the PVA-based resin film in an aqueous solution of iodine. The stretching ratio of the above-mentioned uniaxial stretching is preferably from 3 times to 7 times. The stretching may be performed after the dyeing treatment, or may be performed while the dyeing is performed. In addition, the dyeing may be performed after the stretching. The PVA-based resin film is subjected to, for example, swelling treatment, cross-linking treatment, washing treatment, or drying treatment as required. For example, when the PVA-based resin film is washed with water by being immersed in the water before the dyeing, contamination and an antiblocking agent on the surface of the PVA-based resin film can be washed off. Moreover, the PVA-based resin film can be swollen to prevent dyeing unevenness and the like.

The polarizer obtained by using the laminate is specifically, for example, a polarizer obtained by using: the laminate of a resin substrate and a PVA-based resin layer (PVA-based resin film) laminated on the resin substrate; or the laminate of a resin substrate and a PVA-based resin layer formed on the resin substrate through application. The polarizer obtained by using the laminate of the resin substrate and the PVA-based resin layer formed on the resin substrate through application may be produced, for example, by: applying a PVA-based resin solution to the resin substrate; drying the solution to form the PVA-based resin layer on the resin substrate, to thereby provide the laminate of the resin substrate and the PVA-based resin layer; and stretching and dyeing the laminate to turn the PVA-based resin layer into a polarizer. In at least one embodiment of the present invention, a polyvinyl alcohol-based resin layer containing a halide and a polyvinyl alcohol-based resin is preferably formed on one side of the resin substrate. The stretching typically includes immersing the laminate in an aqueous solution of boric acid to stretch the laminate. Further, the stretching may further include subjecting the laminate to in-air stretching at high temperature (e.g., 95°C or more) before the stretching in the aqueous solution of boric acid as required. In addition, in at least one embodiment of the present invention, the laminate is preferably subjected to drying shrinkage treatment in which the laminate is shrunk in its widthwise direction by 2% or more by being heated while being conveyed in its lengthwise direction. A production method according to at least one embodiment of the present invention typically includes subjecting the laminate to in-air auxiliary stretching treatment, dyeing treatment, underwater stretching treatment, and drying shrinkage treatment in the stated order. When the auxiliary stretching is introduced, even in the case where PVA is applied onto a thermoplastic resin, the crystallinity of the PVA can be improved, and hence high optical characteristics can be achieved. In addition, at the same time, when the alignment property of the PVA is improved in advance, problems, such as a reduction in alignment property of the PVA and the dissolution thereof, at the time of its immersion in water in the subsequent dyeing step or stretching step can be prevented, and hence high optical characteristics can be achieved. Further, in the case where the PVA-based resin layer is immersed in a liquid, the alignment disorder of a polyvinyl alcohol molecule and a reduction in alignment property thereof can be suppressed as compared to the case where the PVA-based resin layer is free of any halide. Thus, the optical characteristics of a polarizer obtained through treatment steps to be performed by immersing the laminate in a liquid, such as dyeing treatment and underwater stretching treatment, can be improved. Further, when the laminate is shrunk in its widthwise direction by the drying shrinkage treatment, its optical characteristics can be improved. The resultant laminate of the resin substrate and the polarizer may be used as it is (i.e., the resin substrate may be used as a protective layer for the polarizer), or may be used after the following: the resin substrate is peeled from the laminate of the resin substrate and the polarizer, and any appropriate protective layer in accordance with purposes is laminated on the peeled surface. Details of such method of producing a polarizer are described in, for example, Japanese Patent Application Laid-open No. 2012-73580 (Japanese Patent No. 5,414,738) and Japanese Patent No. 6,470,455, the descriptions of which are incorporated herein by reference in their entirety.

The iodine content of the polarizer is preferably 2 wt% or more, more preferably from 2 wt% to 10 wt%. The dust cover according to at least one embodiment of the present invention can suppress the polyene formation of the polarizer even when the iodine content of the polarizer falls within such ranges. The term "iodine content" as used herein means the amount of all iodine molecules in the polarizer (PVA-based resin film). More specifically, in the polarizer, iodine is present in the form of, for example, an iodide ion ($I^-$), an iodine molecule ($I_2$), or a polyiodide ion ($I_3^-$ or $I_5^-$), and the term "iodine content" as used herein means the amount of iodine comprehending all of these forms. The iodine content may be calculated by, for example, the calibration curve method of fluorescent X-ray analysis. The polyiodide ion is present under the state of forming a PVA-iodine complex in the polarizer. The formation of such complex can express absorption dichroism in a visible light wavelength range. Specifically, the complex ($PVA \cdot I_3^-$) of the PVA and a triiodide ion has a light absorption peak at around 470 nm, and the complex ($PVA \cdot I_5^-$) of the PVA and a pentaiodide ion has a light absorption peak at around 600 nm. As a result, the polyiodide ion can absorb light in a wide visible light range in accordance with its form. Meanwhile, the iodide ion ($I^-$) has a light absorption peak at around 230 nm, and is hence substantially free from being involved in the absorption of visible light. Accordingly, the polyiodide ion present in the state of a complex with the PVA may be mainly involved in the absorption performance of the polarizer.

The thickness of the polarizer is preferably from 1 um to 30 $\mu$m, more preferably from 1 um to 25 $\mu$m, still more preferably from 1 um to 20 um. When the thickness of the polarizer falls within the above-mentioned ranges, a dust cover having a higher heat-shielding property can be provided.

The polarizer preferably shows absorption dichroism at any wavelength in the wavelength range of from 380 nm to 780 nm. The single layer transmittance Ts of the polarizer is preferably from 40% to 48%, more preferably from 41% to 46%. The polarization degree P of the polarizer is preferably 97.0% or more, more preferably 99.0% or more, still more preferably 99.9% or more. The above-mentioned single layer transmittance is typically a Y value measured with a UV-visible spectrophotometer and subjected to visibility correction. The above-mentioned polarization degree is typically determined from the following equation on the basis of a parallel transmittance Tp and a cross transmittance Tc that have been measured with a UV-visible spectrophotometer and subjected to visibility correction.

$$\mathtt{Polarization\ degree\ (\%)=\{(Tp-Tc)/(Tp+Tc)\}^{1/2}\times 100}$$

C-2. Protective Layer

The protective layers 12 and 13 are each formed from any appropriate film that may be used as a protective layer for the polarizer. As a material serving as a main component of the film, there are specifically given, for example, transparent resins including cellulose-based resins such as triacetylcellulose (TAC), and polyester-based, polyvinyl alcohol-based, polycarbonate-based, polyamide-based, polyimide-based, polyether sulfone-based, polysulfone-based, polystyrene-based, polynorbornene-based, polyolefin-based, (meth)acrylic, and acetate-based resins. There are also given, for example, thermosetting resins or UV-curable resins, such as (meth)acrylic, urethane-based, (meth)acrylic urethane-based, epoxy-based, and silicone-based resins. There are also given, for example, glassy polymers such as a siloxane-based polymer. In addition, a polymer film described in Japanese Panent Application Laid-open No. 2001-343529 (WO 01/37007 A1) may be used. For example, a resin composition containing a thermoplastic resin having a substituted or unsubstituted imide group on a side chain thereof, and a thermoplastic resin having a substituted or unsubstituted phenyl group and a nitrile group on side chains thereof may be used as a material for the film, and the composition is, for example, a resin composition containing an alternating copolymer formed of isobutene and N-methylmaleimide, and an acrylonitrile-styrene copolymer. The polymer film may be, for example, an extrudate of the resin composition.

In at least one embodiment of the present invention, the protective layers may each be formed by using a (meth) acrylic resin. A (meth)acrylic resin having a lactone ring structure is particularly preferred as the (meth)acrylic resin because the resin has high heat resistance, high transparency, and high mechanical strength. Examples of the (meth) acrylic resin having a lactone ring structure include (meth)acrylic resins each having a lactone ring structure described in, for example, Japanese Panent Application Laid-open No. 2000-230016, Japanese Panent Application Laid-open No. 2001-151814, Japanese Panent Application Laid-open No. 2002-120326, Japanese Panent Application Laid-open No. 2002-254544, and Japanese Panent Application Laid-open No. 2005-146084, the descriptions of which are incorporated herein by reference.

Of the protective layers **12** and **13,** the protective layer arranged on the outside of a head-up display apparatus (e.g., the protective layer **12** of the illustrated example) may have any appropriate surface-treated layer. The surface treatment is, for example, surface treatment, such as: hard coat treatment; antireflection treatment; anti-sticking treatment; antiglare treatment; or heat-shielding property-improving treatment, such as flame-retardant treatment or infrared absorption treatment.

The thickness of each of the protective layers is preferably from 10 um to 50 $\mu$m, more preferably from 10 um to 30 um. When the dust cover is subjected to surface treatment, the thickness of the outer protective layer (protective layer **12**) is a thickness including the thickness of its surface-treated layer.

C-3. Other Layer

The polarizing plate **10** may further include any appropriate other layer. The other layer is, for example, a retardation layer. Any appropriate retardation layer may be used as the retardation layer. When the polarizing plate further includes the retardation layer, any appropriate number, kinds, arrangement, and the like may be adopted as the number, kinds, arrangement, and the like of the retardation layers. In at least one embodiment of the present invention, the retardation layer is a $\lambda/4$ plate. In at least one embodiment of the present invention, the in-plane retardation Re(550) of the retardation layer is preferably 3,000 nm or more. Such retardation layer may be arranged on the outside (i.e., a side opposite to the side on which a display unit or the like is stored) of a head-up display apparatus in which the dust cover is adopted. When the in-plane retardation of the retardation layer falls within the above-mentioned range, even in the case where a change in retardation thereof occurs depending on a viewing angle, the retardation of the entirety of the retardation layer is so large that an influence on the viewability of the head-up display apparatus can be reduced. As a result, excellent viewability can be achieved even when a display screen is viewed through a pair of polarized sunglasses. The term "Re($\lambda$)" as used herein refers to the in-plane retardation of a film measured at 23°C with light having a wavelength of $\lambda$ nm. Accordingly, the term "Re(550)" refers to the in-plane retardation of the film measured at 23°C with light having a wavelength of 550 nm. When the thickness of the film is represented by "d" (nm), the Re($\lambda$) is determined from the equation "Re=(nx-ny)$\times$d" where "nx" represents a refractive index in the direction in which a refractive index in the plane of the film becomes maximum (that is, a slow axis direction), and "ny" represents a refractive index in the direction perpendicular to the slow axis in the plane (that is, a fast axis direction).

D. Pressure-sensitive Adhesive Layer

The pressure-sensitive adhesive layers **30** and **30'** may each be formed by using any appropriate pressure-sensitive adhesive. Specific examples of the pressure-sensitive adhesive for forming the pressure-sensitive adhesive layer include an acrylic pressure-sensitive adhesive, a rubber-based pressure-sensitive adhesive, a silicone-based pressure-sensitive adhesive, a polyester-based pressure-sensitive adhesive, a urethane-based pressure-sensitive adhesive, an epoxy-based pressure-sensitive adhesive, and a polyether-based pressure-sensitive adhesive. A pressure-sensitive adhesive having desired characteristics in accordance with purposes can be prepared by adjusting, for example, the kinds, number, combination, and blending ratios of monomers for forming the base resin of the pressure-sensitive adhesive, and the blending amount of a cross-linking agent, a reaction temperature, and a reaction time. The base resins of the pressure-sensitive adhesive may be used alone or in combination thereof. An acrylic pressure-sensitive adhesive is preferred from the viewpoints of, for example, transparency, processability, and durability. Details of the pressure-sensitive adhesive for forming the pressure-sensitive adhesive layer are described in, for example, Japanese Panent Application Laid-open No. 2016-155981, the description of which is incorporated herein by reference. The thickness of the pressure-sensitive adhesive layer may be, for example, from 10 um to 100 $\mu$m.

E. Head-up Display Apparatus

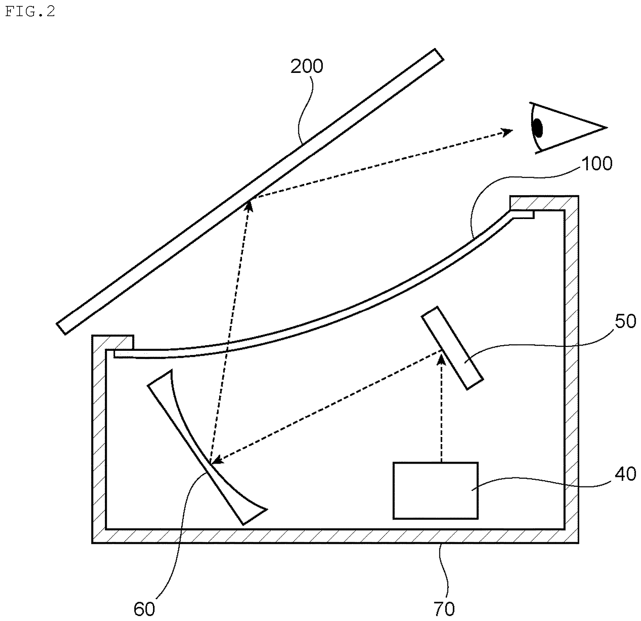

A head-up display apparatus according to at least one embodiment of the present invention includes: a display unit configured to emit projection light; at least one reflector configured to reflect the projection light; and the dust cover described above. FIG. **2** is a schematic sectional view of the head-up display apparatus according to at least one embodiment of the present invention. The head-up display apparatus of the illustrated example includes: a display unit **40** configured to emit projection light; reflectors **50** and **60** configured to reflect the projection light; a housing **70** having stored therein the display unit **40,** and the reflectors **50** and **60;** and the dust cover 100 covering the opening portion of the housing **70**. Although the head-up display apparatus of the illustrated example includes the two reflectors, the number of the reflectors may be one.

In the illustrated example, the projection light emitted from the display unit **40** is reflected by the reflectors **50** and **60.** When the head-up display apparatus is an on-vehicle head-up display apparatus, the projection light reflected by the reflectors is projected onto a windshield **200,** and a projected image may be viewed. As can be seen from the illustrated example, the head-up display apparatus has the opening portion, and hence sunlight may be applied from the opening portion to the inside of the head-up display apparatus to deteriorate a part in the housing such as the display unit. As described above, the head-up display apparatus according to at least one embodiment of the present invention may adopt the dust cover including the iodine-based polarizer as a dust cover. When the dust cover includes the polarizer, the incidence (transmission) of the sunlight into the head-up display apparatus can be suppressed. The iodine-based polarizer has a polarization degree higher than that of any other polarizer such as a dye-based polarizer, and hence can exhibit a high heat-shielding property. As a result, the durability of the head-up display apparatus can be further improved. In addition, the polyene formation of the polarizer is suppressed, and hence the image display performance of the apparatus can be maintained.

Any appropriate configuration may be adopted as the display unit **40.** The display unit is typically, for example, a liquid crystal display apparatus. The liquid crystal display apparatus includes a polarizer, and hence projection light emitted from the liquid crystal display apparatus may be linearly polarized light.

Any appropriate configuration may be adopted as each of the reflectors **50** and **60.** The reflectors **50** and **60** each have, for example, a mirror portion and a mirror holder configured to hold the mirror portion at a predetermined position in the housing **70.** The mirror portion may be a plane mirror, or may be a concave mirror. In the illustrated example, the plane mirror and the concave mirror are adopted as the reflector **50** and the reflector **60,** respectively. The use of the concave mirror enables enlarged display of a video to be projected. The radius of curvature of the concave mirror may be appropriately set in accordance with, for example, purposes and the size of the video to be projected. When the reflector **50** is arranged, the reflector **50** may be, for example, a plane mirror (cold mirror) configured to transmit only an infrared ray and to reflect a visible ray and UV light.

The housing **70** is a box-shaped member having an internal space capable of storing the display unit **40** and the reflectors **50** and **60.** The housing **70** typically has the opening portion, and the projection light emitted from the display unit **40** through the opening portion is emitted to the outside of the housing **70.** The housing **70** may include any appropriate material. When the head-up display apparatus is an on-vehicle head-up display apparatus, a preferred constituent material for the housing **70** is, for example, a material that hardly undergoes a temperature increase due to irradiation with sunlight, and that is easy to form. Specific examples of such material include an acrylic resin, an epoxy-based resin, a polyester-based resin, a urethane-based resin, a polyolefin-based resin, a fluorine-based resin, and a phenoxy-based resin. The housing **70** may be incorporated in a part of an automobile, or may be a member independent of an automobile. For example, a dashboard of an automobile may be used as the housing.

Examples

The present invention is specifically described below by way of Examples. However, the present invention is not limited to these Examples. Measurement methods for characteristics are as described below. Unless otherwise specified, the terms "part(s)" and "%" in Examples and Comparative Examples are by weight.

(1) Thickness

A thickness of 10 um or less was measured with an interference thickness meter (manufactured by Otsuka Electronics Co., Ltd., product name: "MCPD-3000"). A thickness of more than 10 um was measured with a digital micrometer (manufactured by Anritsu Corporation, product name: "KC-351C").

(2) Polyene Formation

The single layer transmittances of a sample before and after a heating test were measured, and a variation $\Delta Ts$ in single layer transmittance was calculated from the following equation. The single layer transmittances were measured with a spectrophotometer (manufactured by Murakami Color Research Laboratory Co., Ltd., product name: "DOT-3") in conformity with JIS Z 8701. The heating test was performed by: cutting a dust cover obtained in each of Examples and Comparative Examples into a size measuring 4.0 cm long by 4.0 cm wide to provide the sample; and placing the sample under the condition of 105°C for 1,000 hours.

$$\Delta Ts = Ts - Ts_0$$

In the equation, $Ts_0$ represents the single layer transmittance of the sample before the heating, and Ts represents the single layer transmittance of the sample after the heating.

A case in which the variation $\Delta Ts$ was a negative value was evaluated as "polyene formation present (NG, the single layer transmittance reduced)," and a case in which the single layer transmittance after the heating was equal to or more than the single layer transmittance before the heating was evaluated as "polyene formation absent."

(3) Warping

The warpings of a sample before and after a heating test were measured, and a variation $\Delta C$ in warping was calculated from the following equation. The warpings were measured with a steel-made linear scale (scaled in increments of 0.5 mm) while the sample was placed on a flat plate. The heating test was performed by: cutting the dust cover obtained in each of Examples and Comparative Examples into a size measuring 25 cm long by 350 cm wide to provide the sample; and placing the sample under the condition of 105°C for 1,000 hours. When the warping was present, each of the samples was placed on the flat plate so that the warping was directed upward (so that the sample had a concave shape). A dimension in a vertical direction between the horizontal surface of the flat plate and the edge of each side of the sample was measured with the linear scale, and the largest value was defined as the warping of the sample.

$$\Delta C = C \ (mm) - C0 \ (mm)$$

In the equation, C0 represents the warping (mm) of the sample before the heating, and C represents the warping (mm) of the sample after the heating.

The sample whose $\Delta C$ was $\pm 15$ mm or more, or the sample having an end portion that curved to be placed inward with respect to the point of inflection of the warping was evaluated as "warping present (NG)."

(4) Moisture Permeability

The moisture permeability of a support plate was measured under the conditions of a temperature of 40°C and a humidity of 92%RH in conformity with JIS Z 0208.

(5) Tensile Modulus of Elasticity

The tensile modulus of elasticity of the support plate was measured under the conditions of a temperature of 23°C $\pm 2$°C and a humidity of 50%RH$\pm 10$%RH in conformity with JIS K 7161.

(6) Iodine Content

A fluorescent X-ray intensity (kcps) corresponding to iodine was measured with a fluorescent X-ray analyzer (manufactured by Rigaku Corporation, product name: "ZSX-PRIMUS IV") . The peak value of a fluorescent X-ray spectrum was adopted as the fluorescent X-ray intensity (kcps). An iodine content was calculated from the following equation by using the fluorescent X-ray intensity per unit thickness of a polarizer thus obtained.

(Iodine content (wt%)) = 14.474 $\times$ (fluorescent X-ray intensity per unit thickness of polarizer) (kcps)

(7) Heat-shielding Property

A 21-centimeter high container having an opening portion (measuring 26.0 cm by 17.5 cm) in its upper portion was regarded as a head-up display apparatus. A thermocouple (manufactured by Chino Corporation, product name: "COVERED THERMOCOUPLE VT6") was loaded into the container, and the dust cover obtained in each of Examples and Comparative Examples was placed in the opening portion. Next, light emitted by the xenon lamp of a single-light source-type solar simulator (manufactured by Yamashita Denso Corporation, product name: "YSS-180S-HS1K") was applied from a position 30 cm above the opening portion for 3 minutes, and an increase in temperature of the thermocouple in the apparatus was measured. The test was performed under the conditions of 23°C$\pm 2$°C and a humidity of 50%RH$\pm 15$%RH. An increase in temperature of 25°C or less means that the dust cover is excellent in heat-shielding property.

(8) Polarization Degree

The transmittance (single layer transmittance) of a polarizer (alone) was measured with a spectrophotometer (manufactured by Murakami Color Research Laboratory Co., Ltd., product name: "DOT-3"). In addition, the same spectrophotometer was used to measure a transmittance (parallel transmittance: $H_0$) when two polarizers of the same kind were superimposed on each other so that the transmission axes of both the polarizers were parallel to each other, and a transmittance (cross transmittance: $H_{90}$) when the polarizers were superimposed on each other so that the transmission axes of both the polarizers were perpendicular to each other. Then, the polarization degree of the polarizer was calculated by applying the parallel transmittance ($H_0$) and the cross transmittance ($H_{90}$) to the following equation.

Polarization degree

$$(\%) = \{ (H_0 - H_{90}) / (H_0 + H_{90}) \}^{1/2} \times 100$$

The single layer transmittance, the parallel transmittance ($H_0$), and the cross transmittance ($H_{90}$) are each a Y value subjected to visibility correction with the two-degree field of view (C light source) of JIS Z 8701.

[Production Example 1] Production of Pressure-sensitive Adhesive Sheet

1. Preparation of Pressure-sensitive Adhesive

100 Parts by weight of toluene, 60 parts by weight of dicyclopentanyl methacrylate (DCPMA) (manufactured by Hitachi Chemical Co., Ltd., product name: "FA-513M"), 40 parts by weight of methyl methacrylate (MMA), and 3.5 parts by weight of a chain transfer agent ($\alpha$-thioglycerol (TGR)) were loaded into a four-necked flask. Next, under a nitrogen atmosphere, the mixture was stirred at 70°C for 1 hour. After that, 0.2 part by weight of azobisisobutyronitrile was loaded as a thermal polymerization initiator into the flask, and the mixture was subjected to a reaction at 70°C for 2 hours, and was subsequently subjected to a reaction at 80°C for 2 hours. After that, the reaction liquid was loaded under an atmosphere at a temperature of 130°C, and toluene, the chain transfer agent, and an unreacted monomer were removed by drying. Thus, a solid (meth)acrylic polymer was obtained. The resultant (meth)acrylic polymer had a glass transition temperature of 144°C and a weight-average molecular weight of 4,300.

Separately, 67 parts by weight of 2-ethylhexyl acrylate (2EHA), 15 parts by weight of N-vinyl-2-pyrrolidone (NVP), 3 parts by weight of hydroxyethyl acrylate (HEA), 15 parts by weight of 4-hydroxybutyl acrylate (4-HBA), 0.05 part by weight of a photopolymerization initiator 1 (manufactured by Ciba Specialty Chemicals, product name: "IRGACURE 184"), and 0.05 part by weight of a photopolymerization initiator 2 (manufactured by Ciba Specialty Chemicals, product name: "IRGACURE 651") were loaded into a four-necked flask. Then, the mixture was exposed to UV light under a nitrogen atmosphere to be partially photopolymerized. Thus, a partially polymerized product (acrylic polymer syrup) having a polymerization ratio of about 10 wt% was obtained.

5 Parts by weight of the above-mentioned (meth)acrylic polymer, 0.04 part by weight of trimethylolpropane triacrylate, and 0.3 part by weight of $\gamma$-glycidoxypropyltrimethoxysilane (manufactured by Shin-Etsu Chemical Co., Ltd., product name: "KBM-403") were added to 100 parts by weight of the resultant acrylic polymer syrup, and the materials were uniformly mixed to provide an acrylic pressure-sensitive adhesive composition.

2. Production of Pressure-sensitive Adhesive Sheet

One surface of a polyester film having a thickness of 38 um (manufactured by Mitsubishi Chemical Polyester Film, product name: "MRF") was subjected to release treatment with silicone. The above-mentioned acrylic pressure-sensitive adhesive composition was applied to the release-treated surface of the film so that its final thickness became 25 um. Thus, an applied layer was formed. Next, one surface of a polyester film having a thickness of 38 um (manufactured by Mitsubishi Chemical Polyester Film, product name: "MRN") was subjected to release treatment with silicone, and the surface of the applied acrylic pressure-sensitive adhesive composition was covered with the film so that the release-treated surface of the film was on an applied layer side. Thus, the applied layer (pressure-sensitive adhesive layer) of the acrylic pressure-sensitive adhesive composition was shielded from oxygen. Next, the resultant pressure-sensitive adhesive layer sheet was irradiated with UV light having an illuminance of 5 mW/cm$^2$ (measured with TOPCON UVR-T1 having the maximum sensitivity at about 350 nm) for 360 seconds through use of a black light lamp (manufactured by Toshiba Corporation). The resultant pressure-sensitive adhesive layer had a gel fraction of 82.4 wt%.

[Example 1]

(Production of Polarizing Film)

A polyvinyl alcohol (PVA) film having an average polymerization degree of 2,700 and a thickness of 45 um was stretched and conveyed while being dyed between rolls having different peripheral speed ratios. First, the PVA film was stretched by a factor of 1.2 in its conveying direction while being swollen through its immersion in a water bath at 30°C for 1 minute. Next, the film was stretched by a factor of 3 (with respect to an unstretched film) in the conveying direction while being dyed through its immersion in an aqueous solution (liquid temperature: 30°C) of potassium iodide (potassium iodide concentration: 0.03 wt%) and iodine (iodine concentration: 0.3 wt%) for 1 minute. Next, the stretched film was stretched by a factor of 6 (with respect to the unstretched film) in the conveying direction while being immersed in an aqueous solution (bath liquid) of boric acid (boric acid concentration: 4 wt%), potassium iodide (potassium iodide concentration: 5 wt%), and zinc sulfate (zinc sulfate concentration: 3.5 wt%) for 30 seconds. After the stretching, the film was dried in an oven at 40°C for 3 minutes to provide a polarizer having a thickness of 18.0 um (iodine content: 3.1 wt%).

(Production of Polarizing Film Laminate)

An aqueous solution containing a polyvinyl alcohol resin containing an acetoacetyl group (average polymerization degree: 1,200, saponification degree: 98.5 mol%, acetoacetylation degree: 5 mol%) and methylolmelamine at a weight ratio of 3:1 was used as an adhesive. Under the temperature condition of 30°C, a transparent protective film having a thickness of 30 um (manufactured by Nitto Denko Corporation), which was formed of a modified acrylic polymer having a lactone ring structure, was bonded to one surface of the polarizer with the adhesive through use of a roll bonding machine, and a triacetylcellulose (TAC)-based film (manufactured by FUJIFILM Corporation, product name: "TJ40UL", thickness: 40 $\mu$m) was bonded to the other surface thereof with the adhesive through use of the machine. Next, the resultant laminate was heated and dried in an oven at 70°C for 5 minutes so that the transparent protective films were bonded to both the surfaces of the polarizer. Each of the adhesive layers had a thickness of from 0.03 um to 1 um.

Separately, 5 parts by weight of a photopolymerization initiator (manufactured by BASF SE, product name: "IRGACURE 906") and 0.01 part by weight of a leveling agent (manufactured by DIC Corporation, product name: "GR_ANDIC PC 4100") with respect to 100 parts by weight of a solid content in a resin solution (manufactured by DIC Corporation, product name: "UNIDIC 17-806", solid content concentration: 80 wt%), which had been obtained by dissolving a UV-curable resin monomer or oligomer containing urethane acrylate as a main component in butyl acetate, were added to the resin solution. Next, cyclopentanone (CPN) and propylene glycol monomethyl ether (PGM) were added at a ratio of 45:55 so that the solid content concentration in the resin solution became 36 wt%. Thus, a hard coat layer-forming material was prepared. The resultant hard coat layer-forming material was applied to the TAC-based film so that the thickness of a hard coat after its curing became 9 um. Thus, a coating film was formed. Next, the coating film was dried at 90°C for 1 minute, and then, UV light having an integrated light quantity of 300 mJ/cm$^2$ was applied from a high-pressure mercury lamp to cure the coating film, to thereby form a hard coat layer on the TAC-based film. Thus, a polarizing plate having the configuration "TAC-based film having formed thereon the hard coat layer (HC-TAC)/polarizer/acrylic transparent protective film" was obtained.

Next, the pressure-sensitive adhesive layer of the pressure-sensitive adhesive sheet obtained in Production Example 1 was transferred onto the HC-TAC side of the polarizing plate, and the polycarbonate resin layer side of a support plate A (manufactured by Wavelock Advanced Technology Co., Ltd., product name: "ShineTech (trademark) AW-10SU", thickness: 200 $\mu$m, polymethyl methacrylate (PMMA) resin layer thickness: 30 um, polycarbonate resin layer thickness: 170 um) and the HC-TAC were bonded to each other. Similarly, the pressure-sensitive adhesive layer was also transferred onto the acrylic transparent protective film side of the polarizing plate, and the polycarbonate resin layer side of the support plate A and the acrylic transparent protective film were bonded to each other. Thus, a dust cover (surface resin layer (PMMA)/substrate (polycarbonate (PC) resin)/polarizer (Pol)/substrate (polycarbonate (PC) resin)/surface resin layer (PMMA)) was obtained. The resultant dust cover was subjected to the above-mentioned evaluations. The results are shown in Table 1.

[Example 2]

A dust cover was obtained in the same manner as in Example 1 except that a support plate B (manufactured by Wavelock Advanced Technology Co., Ltd., product name: "ShineTech (trademark) AW-10SU", thickness: 300 $\mu$m, PMMA resin layer thickness: 35 um, polycarbonate resin layer thickness: 265 $\mu$m) was used instead of the support plate A. The resultant dust cover was subjected to the above-mentioned evaluations. The results are shown in Table 1.

[Example 3]

A dust cover was obtained in the same manner as in Example 1 except that a support plate C (manufactured by Wavelock Advanced Technology Co., Ltd., product name: "ShineTech (trademark) AW-10SU", thickness: 250 um, PMMA resin layer thickness: 30 um, polycarbonate resin layer thickness: 220 $\mu$m) was used as the support plate on the acrylic transparent protective film side of the polarizing plate. The resultant dust cover was subjected to the above-mentioned evaluations. The results are shown in Table 1.

[Example 4]

A dust cover was obtained in the same manner as in Example 1 except that a support plate D (polycarbonate resin film, manufactured by Mitsubishi Gas Chemical Company, Inc., product name: "MRF08U (product class) D51 (product number)", thickness: 300 $\mu$m) was used instead of the support plate A. The resultant dust cover was subjected to the above-mentioned evaluations. The results are shown in Table 1.

## EP 4 485 015 A1

(Comparative Example 1)

A support plate E was obtained by applying the hard coat layer-forming material to a polycarbonate resin film (manufactured by Mitsubishi Gas Chemical Company, Inc., product name: "MRF08U (product class) D51 (product number)", thickness: 175 $\mu$m) in the same manner as in Example 1 so that its thickness after drying became 5 um.

A dust cover was obtained in the same manner as in Example 1 except that the support plate E was used instead of the support plate A. The resultant dust cover was subjected to the above-mentioned evaluations. The results are shown in Table 1.

(Comparative Example 2)

A support plate F was obtained by applying the hard coat layer-forming material to a polycarbonate resin film (manufactured by Mitsubishi Gas Chemical Company, Inc., product name: "MRF08U (product class) D51 (product number)", thickness: 120 $\mu$m) in the same manner as in Example 1 so that its thickness after drying became 5 um.

A dust cover was obtained in the same manner as in Example 1 except that the support plate F was used instead of the support plate A. The resultant dust cover was subjected to the above-mentioned evaluations. The results are shown in Table 1.

(Comparative Example 3)

A dust cover was obtained in the same manner as in Example 1 except that the support plate B was bonded instead of the support plate A to the acrylic transparent protective film side of the polarizing plate. The resultant dust cover was subjected to the above-mentioned evaluations. The results are shown in Table 1.

(Comparative Example 4)

(Production of Polarizing Plate)

0.017 Part by weight of C.I. Direct Orange 39, 0.022 part by weight of C.I. Direct Blue 1, 0.012 part by weight of C.I. Direct Violet 9, and 0.5 part by weight of Glauber's salt per 100 parts by weight of water were dissolved to prepare a dyeing bath. The local maximum absorption wavelengths ($\lambda$max: underwater) of the used dyes were as follows: C.I. Direct Orange 39: about 440 nm; C.I. Direct Blue 1: about 621 nm; and C.I. Direct Violet 9: about 575 nm.

Separately, a film (thickness: 75 um) formed of a polyvinyl alcohol having a polymerization degree of 2,400 was uniaxially stretched by a factor of 6.1 by wet stretching. The film after the stretching was immersed in warm water at 63°C, and was then immersed in the above-mentioned dyeing bath at 73°C to be dyed. Next, the film after the dyeing was immersed in an aqueous solution at 72°C formed of 100 parts by weight of water and 7.8 parts by weight of boric acid. After that, the film was washed with water and dried to provide a polarizer (single layer transmittance: 43.2%, polarization degree: 95.0%, thickness: 28 $\mu$m). A triacetylcellulose film (manufactured by Fuji Photo Film Co., Ltd., thickness: 40 $\mu$m) was bonded to each of both the surfaces of the resultant polarizer to provide a polarizing plate.

A dust cover was obtained in the same manner as in Example 1 except that the resultant polarizing plate was used. The resultant dust cover was subjected to the above-mentioned evaluations. The results are shown in Table 1.

(Comparative Example 5)

A dust cover was obtained in the same manner as in Example 2 except that the polarizing plate used in Comparative Example 4 was used. The resultant dust cover was subjected to the above-mentioned evaluations. The results are shown in Table 1.

(Comparative Example 6)

The support plate A (manufactured by Wavelock Advanced Technology Co., Ltd., product name: "ShineTech (trademark) AW-10SU", thickness: 200 $\mu$m, polymethyl methacrylate (PMMA) resin layer thickness: 30 um, polycarbonate resin layer thickness: 170 um) was used alone and subjected to the above-mentioned evaluations. The results are shown in Table 1.

Table 1

Table 1

| | Configuration | First support plate | | | | Second support plate | | | | Distance between $L_P$ and $L_D$ | Evaluation | | | |
|---|---|---|---|---|---|---|---|---|---|---|---|---|---|---|
| | | Total thickness | Thickness of surface resin layer | Moisture permeability | Tensile modulus of elasticity | Total thickness | Thickness of surface resin layer | Moisture permeability | Tensile modulus of elasticity | | Polyene formation | Warping | Polarization degree | Heat-shielding property |
| | | [µm] | [µm] | [g/m²] | [Mpa] | [µm] | [µm] | [g/m²] | [Mpa] | [µm] | | | [%] | (°C) |
| Example 1 | PMMA/PC/Pol/PC/PMMA | 200 | 30 | 52 | 1,990 | 200 | 30 | 52 | 1,990 | 9.5 | OK | OK | 99.8 | 23.1 |
| Example 2 | PMMA/PC/Pol/PC/PMMA | 300 | 35 | 40 | 2,020 | 300 | 35 | 40 | 2,020 | 9.5 | OK | OK | 99.4 | 22.7 |
| Example 3 | PMMA/PC/Pol/PC/PMMA | 200 | 30 | 52 | 1,990 | 250 | 30 | 48 | 2,000 | 15.5 | OK | OK | 99.7 | 23.1 |
| Example 4 | PC/Pol/PC | 300 | 0 | 41 | 2,100 | 300 | 0 | 41 | 2,100 | 9.5 | OK | OK | – | – |
| Comparative Example 1 | HC/PC/Pol/PC/HC | 180 | 5 | 28 | 2,600 | 180 | 5 | 28 | 2,600 | 9.5 | NG | NG | – | – |
| Comparative Example 2 | HC/PC/Pol/PC/HC | 125 | 5 | 33 | 2,600 | 125 | 5 | 33 | 2,600 | 9.5 | NG | NG | – | – |
| Comparative Example 3 | PMMA/PC/Pol/PC/PMMA | 200 | 30 | 52 | 1,990 | 300 | 35 | 40 | 2,020 | 65 | OK | NG | – | – |
| Comparative Example 4 | HC/PC/Pol/PC/HC | 200 | 30 | 52 | 1,990 | 200 | 30 | 52 | 1,990 | 0 | OK | OK | 95.1 | 28.1 |
| Comparative Example 5 | HC/PC/Pol/PC/HC | 300 | 35 | 40 | 2,020 | 300 | 35 | 40 | 2,020 | 0 | OK | OK | 95 | 27.9 |
| Comparative Example 6 | PC | 200 | 30 | 52 | 1,990 | – | – | – | – | – | – | NG | – | 36.1 |

[Evaluation]

As is apparent from Table 1, in each of the dust covers of Examples of the present invention, the warping and the polyene formation were suppressed. The use of the iodine-based polarizer as a polarizer further improved the heat-shielding property.

The dust cover according to at least one embodiment of the present invention may be suitably used in a head-up display apparatus. The dust cover may be more suitably used in an on-vehicle head-up display apparatus out of such apparatus.

According to at least one embodiment of the present invention, there can be provided the following dust cover: the dust cover is suppressed from warping, and even when an iodine-based polarizer is used, the dust cover can suppress the polyene formation of the polarizer.

**Claims**

1. A dust cover, comprising:

   a first support plate;
   a polarizing plate including an iodine-based polarizer; and
   a second support plate,
   at least one of the first support plate or the second support plate having a moisture permeability of 37 g/(m²·24 hours) or more,
   at least one of the first support plate or the second support plate having a thickness of 200 um or more,
   wherein a distance between a center line $L_P$ of the iodine-based polarizer in a thickness direction thereof and a center line $L_D$ of the dust cover in a thickness direction thereof is 20 um or less.

2. A dust cover, comprising:

   a first support plate;
   a polarizing plate including an iodine-based polarizer; and
   a second support plate,
   at least one of the first support plate or the second support plate having a moisture permeability of 37 g/(m²·24 hours) or more,
   at least one of the first support plate or the second support plate having a tensile modulus of elasticity of 1,600 MPa or more, which is measured at 23°C±2°C,
   wherein a distance between a center line $L_P$ of the iodine-based polarizer in a thickness direction thereof and a center line $L_D$ of the dust cover in a thickness direction thereof is 20 um or less.

3. The dust cover according to claim 1 or 2, wherein the support plates each include a substrate and a surface resin layer.

4. The dust cover according to claim 3, wherein the substrate contains a polycarbonate resin.

5. The dust cover according to claim 3 or 4, wherein the surface resin layer contains polymethyl methacrylate.

6. The dust cover according to any one of claims 3 to 5, wherein the surface resin layer has a thickness of 30 $\mu$m or more.

7. The dust cover according to any one of claims 1 to 6, wherein an iodine content of the polarizer is from 2.2 wt% to 4.0 wt%.

8. A head-up display apparatus, comprising:

a display unit configured to emit projection light;
at least one reflector configured to reflect the projection light; and
the dust cover of any one of claims 1 to 7.

FIG.1

100

FIG.2

Europäisches
Patentamt

European
Patent Office

Office européen
des brevets

# EUROPEAN SEARCH REPORT

Application Number

EP 24 18 3074

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KR 2021 0016702 A (LG CHEMICAL LTD [KR]) 17 February 2021 (2021-02-17) * paragraphs [0081], [0062], [0091], [0059], [0031], [0055], [0018], [0036], [0082], [0004]; figures 5,1 * | 1-8 | INV. G02B1/14 G02B1/18 G02B5/30 G02B27/00 G02B27/01 |
| X | WO 2015/064433 A1 (SUMITOMO CHEMICAL CO [JP]) 7 May 2015 (2015-05-07) * paragraphs [0051], [0052]; figure 1 * | 2 | |
| A | JP 7 116594 B2 (POLATECHNO CO LTD) 10 August 2022 (2022-08-10) * paragraph [0083] * * abstract * | 1-8 | |

**TECHNICAL FIELDS SEARCHED (IPC)**

G02B
G02F
B60K

The present search report has been drawn up for all claims

| Place of search | Date of completion of the search | Examiner |
|---|---|---|
| Munich | 24 October 2024 | Jones, Julian |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

 

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 18 3074

This annex lists the patent family members relating to the patent documents cited in the above-mentioned European search report.
The members are as contained in the European Patent Office EDP file on
The European Patent Office is in no way liable for these particulars which are merely given for the purpose of information.

24-10-2024

| Patent document cited in search report | Publication date | Patent family member(s) | Publication date |
|---|---|---|---|
| KR 20210016702 A | 17-02-2021 | NONE | |
| WO 2015064433 A1 | 07-05-2015 | CN 105683788 A | 15-06-2016 |
| | | CN 107703578 A | 16-02-2018 |
| | | JP 5952505 B2 | 13-07-2016 |
| | | JP 6042576 B2 | 14-12-2016 |
| | | JP 2016167098 A | 15-09-2016 |
| | | JP WO2015064433 A1 | 09-03-2017 |
| | | KR 20160078389 A | 04-07-2016 |
| | | KR 20180034709 A | 04-04-2018 |
| | | TW 201527480 A | 16-07-2015 |
| | | US 2016252660 A1 | 01-09-2016 |
| | | US 2017282506 A1 | 05-10-2017 |
| | | US 2020130332 A1 | 30-04-2020 |
| | | WO 2015064433 A1 | 07-05-2015 |
| JP 7116594 B2 | 10-08-2022 | CN 112513693 A | 16-03-2021 |
| | | JP 7116594 B2 | 10-08-2022 |
| | | JP 2019211490 A | 12-12-2019 |
| | | KR 20210014671 A | 09-02-2021 |
| | | TW 202004233 A | 16-01-2020 |
| | | WO 2019230516 A1 | 05-12-2019 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2017199916 A1
- JP 2012073580 A
- JP 5414738 B
- JP 6470455 B
- JP 2001343529 A
- WO 0137007 A1
- JP 2000230016 A
- JP 2001151814 A
- JP 2002120326 A
- JP 2002254544 A
- JP 2005146084 A
- JP 2016155981 A